# EUROPÄISCHE PATENTSCHRIFT

(11) **EP 1 267 404 B1**
(45) Veröffentlichungstag und Bekanntmachung des Hinweises auf die Patenterteilung: **09.05.2007**
(21) Anmeldenummer: 02012804.7
(22) Anmeldetag: 10.06.2002
(51) Int. Cl.: H01L 23/498, H01L 23/495

(54) **Verpackung für ein elektronisches Bauelement**
Package for an electronic device
Boîtier pour un dispositif électronique

(30) Priorität: 13.06.2001 DE 10128756
(43) Veröffentlichungstag der Anmeldung: 18.12.2002
(73) Patentinhaber: ROBERT BOSCH GMBH, 70442 Stuttgart (DE)
(72) Erfinder: Weiblen, Kurt, 72555 Metzingen (DE); Stratmann, Andreas, 72810 Gomaringen (DE); Zappel, Bernhard, 72669 Unterensingen (DE)

(56) Entgegenhaltungen:
- US-A- 3 947 867
- US-A- 5 304 818
- PATENT ABSTRACTS OF JAPAN Bd. 2000, Nr. 16, 8. Mai 2001 (2001-05-08) -& JP 2001 024132 A (TEXAS INSTR INC <TI>), 26. Januar 2001 (2001-01-26) -& US 2002/190358 A1 (ARGUELLES RONALDO M ET AL) 19. Dezember 2002 (2002-12-19)
- PATENT ABSTRACTS OF JAPAN Bd. 1997, Nr. 07, 31. Juli 1997 (1997-07-31) -& JP 09 064266 A (SONY CORP), 7. März 1997 (1997-03-07)

## Beschreibung

### Stand der Technik

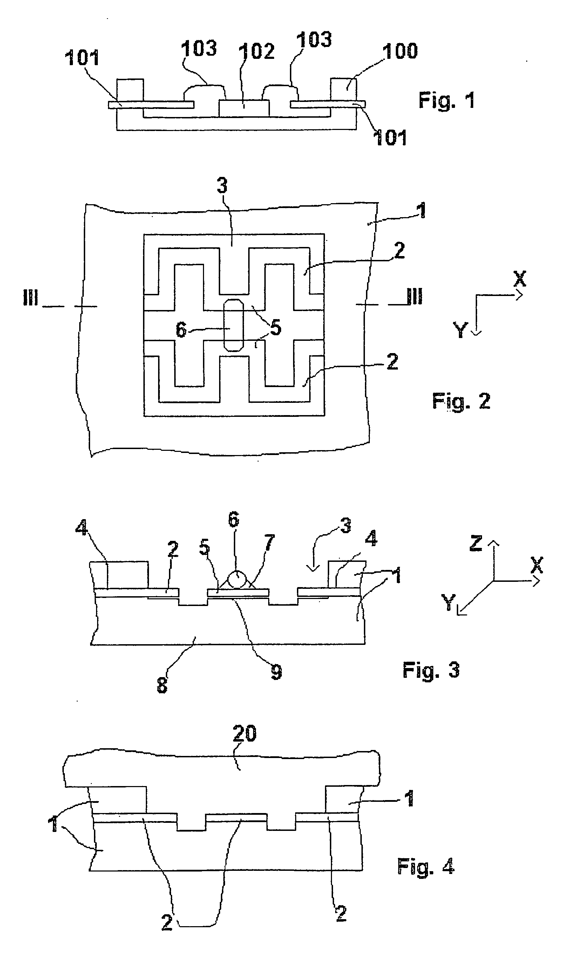

Die Erfindung geht aus von einer Verpackung für ein elektronisches Bauelement nach der Gattung des unabhängigen Patentanspruchs. Es sind bereits Verpackungen für elektronische Bauelemente bekannt, die in der Figur 1 im Querschnitt gezeigt werden. Die Verpackung nach der Figur 1 weist ein Kunststoffgehäuse 100 auf, in dem Metalleinlegeteile 101 eingebettet sind. Diese metallischen Einlegeteile werden aus Metallblechen herausgestanzt und werden bei der Herstellung des Kunststoffgehäuses 100 mit in die Kunststoffmasse eingebettet. Dies erfolgt, indem die Kunststoffgehäuse 100 durch Spritzguß gefertigt werden und in die Spritzgußform vor dem Befüllen mit Kunststoff die metallischen Einlegeteile 100 eingelegt werden. Nach dem Befüllen der Spritzgußform sind diese Einlegeteile 101 dann fest in das Kunststoffmaterial des Gehäuses 100 eingebettet. Weiterhin wird in der Figur 1 ein elektronisches Bauelement 102 gezeigt, welches mit Bonddrähten 103 mit den Metalleinlegeteilen 101 elektrisch verbunden ist. Die Bonddrähte 103 sind dabei elastisch ausgebildet und können somit bei einer Relativbewegung des Bauteils 102 relativ zu den Einlegeteilen 101 bzw. relativ zum Gehäuse 100 entsprechend verformt werden. Eine direkte Verbindung der elektronischen Bauelemente 102 mit den Einlegeteilen 101 ist problematisch, da aufgrund der unterschiedlichen Ausdehnungskoeffizienten der verwendeten Materialien, insbesondere des Kunststoffs des Gehäuses und der metallischen Einleteile 101, es zu unterschiedlichen thermischen Ausdehnungen der beteiligten Materialien kommt. Eine starre Verbindung zwischen den Einlegeteilen und den elektronischen Bauelementen 102 müsste somit große Kräfte aushalten, die durch die unterschiedlichen thermischen Ausdehnungskoeffizienten verursacht werden. Insbesondere die Verbindung zwischen den elektronischen Bauelementen 102 und den Einlegeteilen 101 wäre stark gefährdet, da diese Verbindung in der Regel durch ein Lot oder einen leitenden Kleber erfolgt, die nicht zur Aufnahme von großen Kräften geeignet sind.

Weitere Verpackungen werden in den Dokumenten US 3947867, JP 2001024132 und JP 09064266 beschrieben.

### Vorteile der Erfindung

Die erfindungsgemäße Verpackung für ein elektronisches Bauelement hat den Vorteil, dass metallische Träger, die in dem Kunststoffmaterial eingebettet sind, unmittelbar mit den elektronischen Bauelementen verbunden werden können. Die zusätzliche Verbindung über die Bonddrähte kann daher entfallen und eine derartige Verpackung kann daher besonders einfach und kostengünstig gefertigt werden. Weiterhin wird durch die direkte Ankopplung des elektronischen Bauelements mit dem metallischen Träger die Ableitung von Wärme verbessert.

Weitere Vorteile und Verbesserungen ergeben sich durch die Merkmale der abhängigen Patentansprüche. Die elastische Auslegung des Trägers erfolgt besonders einfach durch Ausbildung einer mäanderartigen Struktur. Die elektronischen Bauelemente können auch direkt zwischen zwei Trägern montiert werden, die dann zweckmäßigerweise auch gleich die Kontaktierungen bilden. Besonders einfach erfolgt die Befestigung durch Lot oder Kleber. Besonders einfach wird der metallische Träger als Stanzteil aus einem Blech herausgebildet. Der Kunststoffträger wird besonders einfach durch Spritzguß gefertigt.

### Zeichnungen

Ausführungsbeispiele der Erfindung werden in den Zeichnungen dargestellt und in der nachfolgenden Beschreibung näher erläutert. Es zeigen Figur 1 einen Querschnitt durch eine herkömmliche Verpackung, Figur 2 eine Aufsicht auf eine erfindungsgemäße Verpackung, Figur 3 einen Querschnitt durch Figur 2 und Figur 4 einen Zwischenschritt des Herstellungsverfahrens.

### Beschreibung

In der Figur 2 wird eine Aufsicht auf die erfindungsgemäße Verpackung für ein elektronisches Bauelement gezeigt. In der Figur 3 wird ein Querschnitt entlang der Linie III-III der Figur 2 gezeigt. Wie in der Aufsicht der Figur 2 zu erkennen ist, weist die Verpackung ein Kunststoffgehäuse 1 auf, in dem metallische Einlegeteile 2 eingebettet sind. Die metallischen Einlegeteile 2 erstrecken sich zum Teil in eine Ausnehmung 3 des Kunststoffgehäuses 1 und zum Teil sind sie von der Kunststoffmasse des Kunststoffgehäuses 1 umschlossen. Die Bereiche, in denen die metallischen Einlegeteile vom Kunststoff des Kunststoffgehäuses 1 umschlossen sind, werden im Folgenden als Einbettbereiche 4 bezeichnet. Derartige Einbettbereiche 4, in denen ein metallisches Einlegeteil 2 von oben und unten von der Kunststoffmasse umschlossen ist, wird beispielsweise im Querschnitt in der Figur 3 gezeigt. Im Bereich der Ausnehmung 3 ist ein elektronisches Bauelement 6 auf den metallischen Einlegeteilen 2 befestigt. Der Bereich, in dem das elektronische Bauelement 6 befestigt ist, wird im Folgenden als Befestigungsbereich 5 bezeichnet.

In der Figur 3 wird schematisch die Befestigung des elektronischen Bauelements 6 auf dem Befestigungsbereich 5 durch ein Lot 7 gezeigt. Alternativ zu einer Befestigung durch Löten kann auch eine Befestigung durch einen leitfähigen Kleber erfolgen.

Unter den Einlegeteilen 2 im Bereich der Ausnehmung 3 ist das Kunststoffgehäuse als Boden 8 ausgebildet, der sich unter dem gesamten Bereich der Ausnehmung 3 erstreckt. Zwischen dem Boden 8 und den Einlegeteilen 2 ist ein geringer Abstand 9 vorgesehen. Die Größe dieses Abstandes wird überwiegend dadurch bestimmt, dass bei der Herstellung des Kunststoffgehäuses 1 ein gewisses Schrumpfen des Kunststoffmaterials erfolgt, wodurch sich dann der Abstand 9 zwischen den Einlegeteilen 2 und dem Boden 8 ergibt. Dieser Abstand 9 kann sehr gering sein, so dass die Einlegeteile im Wesentlichen auf dem Boden 8 aufliegen. Der Boden 8 ist nicht unbedingt plan ausgebildet, insbesondere können die Bereiche, über denen nicht die Einlegeteile 2 angeordnet sind, vertieft sein. Dies hängt mit dem Herstellungsverfahren zusammen wie es in der Figur 4 noch weiter erläutert wird.

Wie in der Aufsicht der Figur 2 zu erkennen ist, sind die Einlegeteile 2 mäanderförmig ausgebildet. Durch diese mäanderförmige Struktur der Einlegeteile 2 wird es ermöglicht, dass sich die Einlegeteile 2 im Bereich der Ausnehmung 3 relativ zum Kunststoffgehäuse 1 in lateraler Richtung bewegen können. Dies ist insbesondere wichtig, da sich die thermischen Ausdehnungskoeffizienten der metallischen Einlegeteile 2 und des Materials des Kunststoffgehäuses 1 stark unterscheiden. Durch diese unterschiedlichen thermischen Ausdehnungskoeffizienten kommt es bei Temperaturveränderungen zu mechanischen Verspannungen zwischen dem Kunststoffgehäuse 1 und den metallischen Einlegeteilen 2. Weiterhin können auch mechanische Spannungen zwischen den beiden metallischen Einlegeteilen 2 auftreten, da diese ja von dem Kunststoffgehäuse 1 gehalten werden.

Zum Abbau dieser Spannungen sind die metallischen Einlegeteile 2 im Bereich der Ausnehmung 3 in lateraler Richtung verformbar ausgebildet. Unter lateraler Richtung wird hier die Richtung verstanden, die senkrecht zur Dicke der Einlegeteile 2 ist. In lateraler Richtung wird in der Figur 2 die gesamte Papierebene d.h. die XY-Ebene verstanden. In der Figur 3 ist ein Koordinatensystem gezeigt, in dem die laterale Richtung durch die XY-Ebene gebildet wird. Unter der Dicke der Einlegeteile 2 wird die Ausdehnung in Z-Richtung verstanden. Durch die mäanderförmige Struktur der Einlegeteile 2 wie sie in der Aufsicht der Figur 2 zu erkennen ist, wird erreicht, dass die Einlegeteile 2 in XY-Ebene verformbar sind. Auftretende mechanische Verspannungen können so einfach durch eine Verformung der Einlegeteile 2 abgebaut werden.

Wesentlich ist dies für die Befestigung des elektronischen Bauelements 6 auf den Einlegeteilen 2. Die Verbindung des elektronischen Bauelements 6 mittels einer Verbindungsmasse 7, die durch ein Lot oder einen leitfähigen Kleber gebildet wird, sollte nicht durch starke mechanische Kräfte beaufschlagt werden. Da die Einlegeteile 2 in lateraler Richtung verformbar ausgebildet sind, werden die thermisch bedingten Verspannungen weitgehend durch eine Verformung abgebaut. Die Befestigungsmasse 7 wird daher mechanisch nicht zu stark beansprucht. Weiterhin sind die metallischen Einlegeteile bezüglich des elektronischen Bauelements 6 symmetrisch ausgebildet, so dass sich an den Befestigungsbereichen 5 die Kräfte zumindest teilweise gegenseitig kompensieren. Es wird so eine Verpackung für das elektronische Bauelement 6 geschaffen, bei der die Verbindung zwischen dem Bauelement 6 und den Einlegeteilen 2 mechanisch nicht stark belastet wird und somit über lange Zeiten beständig ist.

Gezeigt wurde hier ein Bauelement 6, welches zwischen zwei Einlegeteilen 2 angeordnet ist. Die Erfindung ist aber ebenso nützlich, wenn das Bauelement 6 nur auf einem Einlegeteil oder mit mehr als zwei Einlegeteilen verbunden ist. Wesentlich ist dabei immer, dass zwischen der Verbindungsstelle des Einlegeteils 2 mit dem Bauelement und dem Kunststoffgehäuse ein lateral verformbarer Bereich angeordnet ist.

In der Figur 4 wird die Herstellung der erfindungsgemäßen Verpackung erläutert. Dabei wird ein Querschnitt durch die erfindungsgemäße Verpackung während des Spritzgießens gezeigt. In dem Querschnitt in der Figur 4 wird ein Querschnitt durch das Kunststoffgehäuses 1 und ein Einlegeteil 2 während des Spritzgießens gezeigt. Der Querschnitt entspricht der gleichen Stelle wie sie in der Figur 2 gezeigt wird. Wie zu erkennen ist, wird der Hohlraum 3 der Figur 3 beim Spritzgießen von einem Formwerkzeug 20 ausgefüllt. Das Formwerkzeug 20 ist dabei so ausgeformt, dass es nicht nur den Hohlraum 3 ausfüllt, sondern auch dass es den Raum um die Einlegeteile 2 in Richtung auf den Boden 8 hin vollständig ausfüllt. Es werden so die in der Figur 3 gezeigten Vertiefungen eingebracht. Auf diese Weise wird verhindert, dass die Kunststoffmasse sich auch in der XY-Ebene zwischen verschiedenen Bereichen der Einlegeteile 2 anordnet. Wenn sich dort nämlich Kunststoffmasse befindet, wird die Beweglichkeit, d.h. die Verformbarkeit, der Einlegeteile 2 in der XY-Ebene beeinträchtigt und der gewünschte Abbau von mechanischen Spannungen durch Verformung der Einlegeteile 2 könnte nicht erfolgen. Das spezielle Formwerkzeug 20 verhindert, dass sich beim Spritzgießen zwischen einzelnen Bereichen der Einlegeteile 2 Kunststoffmaterial ansammelt, welches eine Verformung der Einlegeteile 2 in der XY-Ebene behindern könnte.

## Patentansprüche

1. Verpackung für ein elektronisches Bauelement (6) mit einem metallischen Einlegeteil (2) und einem Kunststoffgehäuse (1), in dem das metallische Einlegeteil (2) mit einem Einbettbereich (4) eingebettet ist,
- wobei eine Dicke des metallischen Einlegeteils (2) gering ist im Vergleich zu seiner lateralen Abmessung,
- wobei auf dem metallischen Einlegeteil (2) das Bauelement (6) auf einem Befestigungsbereich (5) leitfähig befestigt ist,
- wobei das metallische Einlegeteil (2) zwischen Einbettbereich (4) und Befestigungsbereich (5) in lateraler Richtung verformbar ausgebildet ist
**dadurch gekennzeichnet**
- **dass** das Kunststoffgehäuse (1) einen Boden (8) aufweist, der sich unter dem Befestigungsbereich (5) des metallischen Einlegeteils (2) mit einem Abstand (9) erstreckt, der geringer ist als die Dicke des metallischen Einlegeteils (2) und
- **dass** das Kunststoffgehäuse (1) eine Ausnehmung (3) aufweist, in deren Bereich das Bauelement (6) auf dem metallischen Einlegeteil (2) befestigt ist.

2. Verpackung nach Anspruch 1, **dadurch gekennzeichnet, dass** das metallische Einlegeteil (2) zwischen Einbettbereich (4) und Befestigungsbereich (5) als mäanderartige Struktur ausgebildet ist.

3. Verpackung nach Anspruch 1 oder 2, **dadurch gekennzeichnet, dass** mindestens zwei metallische Einlegeteile (2) vorgesehen sind, die jeweils einen Befestigungsbereich (5) aufweisen und dass das elektronische Bauelement (6) auf beiden Befestigungsbereichen (5) befestigt ist.

4. Verpackung nach einem der vorhergehenden Ansprüche, **dadurch gekennzeichnet, dass** die Befestigung des elektronischen Bauelements (6) auf den Befestigungsbereichen (5) durch ein Lot (7) oder einen Kleber (7) erfolgt.

5. Verpackung nach einem der vorhergehenden Ansprüche, **dadurch gekennzeichnet, dass** das metallische Einlegeteil (2) durch Stanzen eines Metallblechs gebildet ist.

6. Verpackung nach einem der vorhergehenden Ansprüche, **dadurch gekennzeichnet, dass** das Kunststoffgehäuse (1) ein Spritzgussgehäuse ist.

## Claims

1. Package for an electronic device (6) having a metallic insert part (2) and a plastic housing (1), in which the metallic insert part (2) is embedded with an embedding region (4),
- the thickness of the metallic insert part (2) being small in comparison with its lateral dimension,
- the device (6) being conductively fastened on the metallic insert part (2) on a fastening region (5),
- the metallic insert part (2) being formed between the embedding region (4) and the fastening region (5) in such way that it can be deformed in the lateral direction,
**characterized**
- **in that** the plastic housing (1) has a base (8) which extends under the fastening region (5) of the metallic insert part (2) with a spacing (9) which is smaller than the thickness of the metallic insert part (2) and
- **in that** the plastic housing (1) has a recess (3), in the region of which the device (6) is fastened on the metallic insert part (2).

2. Package according to Claim 1, **characterized in that** the metallic insert part (2) is formed between the embedding region (4) and the fastening region (5) as a meandering structure.

3. Package according to Claim 1 or 2, **characterized in that** at least two metallic insert parts (2) are provided, respectively having a fastening region (5), and **in that** the electronic device (6) is fastened on both fastening regions (5).

4. Package according to one of the preceding claims, **characterized in that** the fastening of the electronic device (6) on the fastening regions (5) is performed by a solder (7) or an adhesive (7).

5. Package according to one of the preceding claims, **characterized in that** the metallic insert part (2) is formed by stamping a metal sheet.

6. Package according to one of the preceding claims, **characterized in that** the plastic housing (1) is an injection-moulded housing.

## Revendications

1. Emballage pour un composant électronique (6) comportant un insert métallique (2) et un boîtier en plastique (1) logeant une certaine zone d'encastrement (4) de l'insert métallique (2) dont l'épaisseur est faible par rapport à sa dimension latérale,
le composant (6) étant fixé de manière conductrice sur une zone de fixation (5), de l'insert métallique (2), et
l'insert métallique (2) étant déformable entre la zone d'encastrement (4) et la zone de fixation (5) dans la direction latérale,
**caractérisé en ce que**
le boîtier en plastique (1) présente un fond (8) qui se prolonge sous la zone de fixation (5) de l'insert métallique (2) à une distance (9) plus faible que l'épaisseur de l'insert métallique (2), et le boîtier en plastique (1) présente un évidement (3) dans la zone où le composant (6) est fixé sur l'insert métallique (2).

2. Emballage selon la revendication 1,
**caractérisé en ce que**
l'insert métallique (2) est conçu avec des méandres entre la zone d'encastrement (4) et la zone de fixation (5).

3. Emballage selon la revendication 1 ou 2,
**caractérisé en ce qu'**
au moins deux inserts métalliques (2) présentent chacun une zone de fixation (5) et le composant électronique (6) est fixé sur les deux zones de fixation (5).

4. Emballage selon l'une des revendications précédentes,
**caractérisé en ce que**
la fixation du composant électronique (6) sur les zones de fixation (5) s'effectue par une brasure (7) ou une colle (7).

5. Emballage selon l'une des revendications précédentes,
**caractérisé en ce que**
l'insert métallique (2) est découpé à l'emporte-pièce dans une tôle métallique.

6. Emballage selon l'une des revendications précédentes,
**caractérisé en ce que**
le boîtier en plastique (1) est moulé par injection.
